Europäisches Patentamt

European Patent Office

Office européen des brevets

(11) Publication number: **0 149 178 B1**

# EUROPEAN PATENT SPECIFICATION

(45) Date of publication of patent specification: **27.02.91**

(51) Int. Cl.5: **H01L 31/109, H01L 31/0352, H01L 27/14, H01L 31/06**

(21) Application number: **84115765.4**

(22) Date of filing: **19.12.84**

(54) **Infrared detector system based on III-V epitaxial material.**

(30) Priority: **13.01.84 US 570463**

(43) Date of publication of application:
**24.07.85 Bulletin 85/30**

(45) Publication of the grant of the patent:
**27.02.91 Bulletin 91/09**

(84) Designated Contracting States:
**DE FR GB**

(56) References cited:
**GB-A- 2 107 927**
**US-A- 4 450 463**

**ELECTRONICS LETTERS, vol. 15, no. 8, 12th April 1979, pages 238-240, Hitchin, Herts, GB; N. SUSA et al.: "Planar photodiodes made from vapour phase epitaxial InxGa1-xAs"**

**APPLIED PHYSICS LETTERS, vol. 43, no. 11, 1st December 1983, pages 1040-1042, New York, US; F. CAPASSO et al.: "New long wavelength Al0.48In0.52As/Ga0.47In0.53As avalanche photodiode grown by molecular beam epitaxy"**

(73) Proprietor: **TEXAS INSTRUMENTS INCORPORATED**
**13500 North Central Expressway**
**Dallas Texas 75265(US)**

(72) Inventor: **Lewis, Adam J.**
**2425 Fairway Drive**
**Richardson, TX 75080(US)**
Inventor: **Frensley, William R.**
**1606 Drake Drive**
**Richardson, TX 75081(US)**

(74) Representative: **Leiser, Gottfried, Dipl.-Ing. et al**
**Patentanwälte Prinz, Leiser, Bunke & Partner**
**Manzingerweg 7**
**D-8000 München 60(DE)**

## Description

Background of the Invention

Field of the Invention

This invention relates to an infrared detector device for detecting infrared radiation which employs a Group III-V compound semiconductor material.

Description of the Prior Art

There presently exists a large market for systems which can detect infrared radiation, especially for night vision. Detector systems for infrared radiation are well known in the prior art and exist in many different forms. Infrared radiation detection systems which have found a great deal of acceptance in recent years have been based upon an alloy of mercury, cadmium and tellurium in stoichiometric amounts with the ratio of mercury to cadmium being adjustable to tune the material to the frequency of the infrared radiation. Such materials are known in the art as HgCdTe to include the broad spectrum of these materials. These HgCdTe materials are presently the preferred materials for second generation infrared detection systems.

Despite the great acceptance of the prior art mercury, cadmium, telluride materials, these materials are subject to certain problems such as crystal size and purity, maturity of integrated circuit technology, optical currents, the relative instability of the surfaces thereof due to anodic oxidation which provides interfaces that are unable to stand up to 100° C environmental conditions, and the like. It is therefore desirable that, not only should the prior art HgCdTe technology be improved, but also, it is desirable that other materials be explored for infrared detectors which have properties superior to those found in existing systems.

In APPLIED PHYSICS LETTERS, vol. 43, no. 11, 1st December 1983, pages 1040-1042, New York, US; F. CAPASSO et al.: "New long wavelength AlO.48lnO.52As/GaO.47lnO.53As avalanche photodiode grown by molecular beam epitaxy" an infrared detector having a III-V substrate with a first layer of doped III-V material is disclosed. Said detector further includes a second layer of moderate band gap III-V material and a third layer of III-V material having a wider bandgap than the second layer.

Summary of the Invention

In accordance with the present invention, there is provided a detector for infrared radiation which is based on photoexcitation of carriers over a semiconductor heterojunction for collection, a simple heterojunction could be made of gallium arsenide and aluminum gallium arsenide: a photon would be absorbed in the gallium arsenide by an electron which would then have sufficient energy to pass into the aluminum gallium arsenide where it would be detected. However, the quantum efficiency for such essentially free carrier absorption of a photon is low due to the lack of conservation of energy and momentum.

In order to provide a higher quantum efficiency from a direct photon absorption process, the gallium arsenide infrared absorbing layer is replaced with an artificial superlattice structure. A superlattice is a lattice wherein the continuous energy bands of the conduction band are split up with very small gaps due to the periodic (lattice) structure. The lattice structure is preferably composed of N-type doped gallium arsenide wherein, at spaced intervals, aluminum replaces some of the gallium sites. The spacing between the spaced sites is determined by the frequency of the infrared radiation to be detected.

Thus, the present invention teaches a junctionless infrared detector, where in photons are absorbed by conduction-band transitions in an absorbtion layer. The carriers thus excited by conduction-band transitions are injected over an injection barrier, which is a heterojunction, and are preferably then collected against a further heterojunction collection barrier. The carriers collected at the collection barrier can then be periodically sensed. Preferably the absorption layer is a superlattice structure, so that the infrared photons can be absorbed by essentially direct conduction band transitions, rather than the necessarily indirect conduction-band transition in a normal semiconductor.

An infrared detector in accordance with the present invention comprises a conductive substrate of a Group III-V material, preferably gallium arsenide. Upon this substrate is deposited the above described superlattice-type structure of alternating thin layers of a wider and then a narrower energy band gap semiconductor material, aluminum gallium arsenide and gallium arsenide being the preferable materials. Upon this lattice structure there is deposited a layer of an alloyed semiconductor material of moderate band gap, aluminum gallium arsenide being the preferred material, into which photo-excited carriers are injected. Upon this layer is deposited a further layer of wider band gap material, aluminum gallium arsenide with different aluminum-gallium ratio being preferred.

The superlattice structure is designed so that the energy gap between the first two "mini-bands", produced by the periodic lattice structure is equal to or less than the infrared photon energy. The doping is such as to nearly fill the first "mini-band" with free carriers. Thus, infrared radiation will be efficiently absorbed, generating free carriers in the second mini-band, etc. The band gap of the next layer is chosen so that these photo excited carriers may easily pass over the heterojunction into this layer, while those in the lower energy mini-band are blocked. These carriers are propelled across the layer by an applied electric field and are collected at the interface or heterojunction with the next wide-gap layer. Alternatively, a metal gate electrode is provided over an insulator at the top surface of the device. The above described device displays clear advantages over the prior art mercury cadmium telluride infrared detectors in that large area substrates can be provided, and more mature integrated circuit technology is available and a more stable interface for charge storage is provided. In addition dark currents are significantly smaller than the optical currents.

Brief Description of the Drawings

Figure 1 is a circuit diagram of an imaging device using the photocapacitor detectors in accordance with the present invention,

Figure 2 is a schematic diagram of a photocapacitor detector in accordance with the present invention,

Figure 3 is an enlarged view of layer 13 of the detector of Figure 2,

Figure 4 is a graph of the conduction band profile of the detector of Figures 2 and 3, and

Figure 5 shows the band structure of the superlattice in more detail, showing the first and second mini-bands within the conduction band.

Description of the Preferred Embodiment

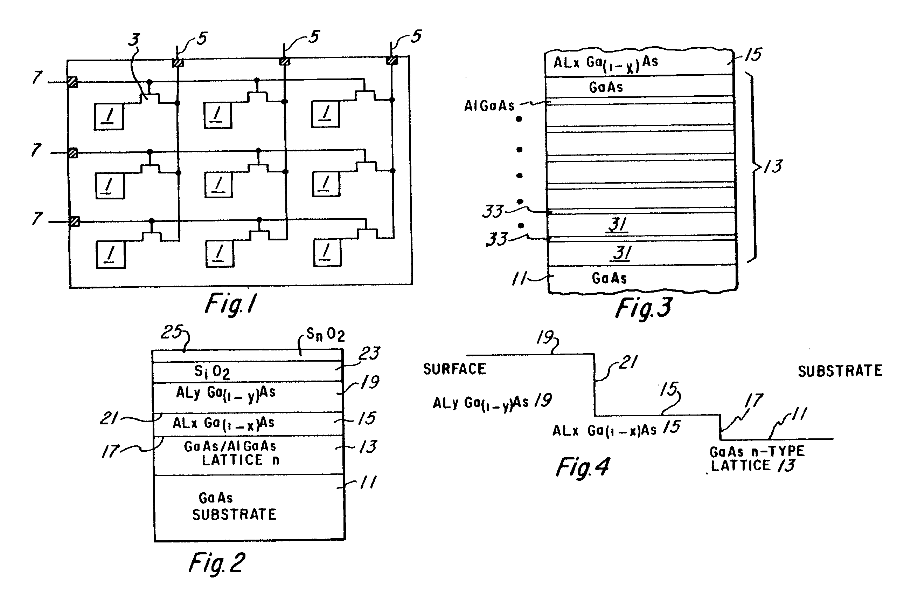

Referring first to Figure 1, there is shown a typical infrared imaging device having a plurality of infrared detector cells 1 formed on a substrate of gallium arsenide 11 (Fig. 2), which is undoped or slighly doped, each of the cells being coupled via an FET device 3 to column lines 5 and row lines 7 in a matrix arrangement whereby any one of the cells 1 can be addressed in well known manner.

As shown in Figure 2, each of the cells 1 includes a substrate of gallium arsenide 11 (e.g. doped $1\times10^{17}$ n-type). An N-type gallium arsenide superlattice 13 is formed over the substrate 11 having a superlattice structure wherein aluminum replaces some of the gallium at various levels between the substrate 11 and the layer 15 as will be explained in greater detail hereinbelow. The interface of the absorption layer 13 and the collection layer 15 is provided by an aluminum discontinuity, wherein a larger predetermined amount of aluminum is present in layer 15 to replace some of the gallium sites and form a gallium arsenide to aluminum gallium arsenide heterojunction 17. The junction 17 confines the electrons extant in the lattice structure 13 therein. A barrier layer 19, preferably a further aluminum gallium arsenide layer 19 with a larger aluminum fraction (wider bandgap) than layer 15 is provided with a sudden increase in the amount of aluminum provided at the heterojunction 21 between the layers 15 and 19. This sudden jump increase in the amount of aluminum in the layer provides a collection point so that electrons which are photoexcited over the heterojunction 17 into the layer 15 will be collected against the barrier formed at the heterojunction 21. Alternatively, an insulating layer 23 is provided in place of or over the layer 19, silicon dioxide being a preferred insulator. A preferably transparent conductive layer 25 is formed over the insulating layer 23, tin oxide and indium tin oxide (ITO) being preferred materials for this purpose.

Referring now to Figure 3, the layer 13 and its superlattice structure is shown in greater detail. As can be seen, a layer of N-type doped gallium arsenide 31 is formed over the substrate 11, preferably by molecular beam epitaxy (MBE) to a predetermined layer height whereupon aluminum is added to the deposit to form a thin layer of aluminum gallium arsenide 33. This procedure continues on an alternating basis for the entire height of the layer 13. The regions with aluminum 33 are equally spaced from each other and the spacing therebetween is determined by the wave length of the infrared radiation to be received, it being apparent that the layer 13 is tuned to the frequency of radiation to be detected. The structure of Figure 3 provides a high degree of efficiency to the detector element.

In actual operation, photons of infrared radiation will impinge upon the layer 13 and excite electrons therein by transfer of energy thereto. Those electrons that receive sufficient energy from the photons will be able to scale the barrier or heterojunction 17 between the layer 13 and the layer 15 as shown in Figure 4 and move into the layer 15 by traveling over the barrier 17. Superlattice layer 13 is shown simplified. The electrons that travel into layers 15 will then be collected against the heterojunction or barrier 21 which is the interface between the layers 15 and 19 (or 15 and 23, if layer 19 is not used). With the electrons collected at the barrier 21, it can be seen that an appropriate sensing of the cell by the row and column lines 5 and 7 as shown in Figure 1 will cause detection of the charge on each of the formed capacitors to be sensed without loading the sense line down with capacitance from the addressed row.

The operation of the various embodiments of the inventive device will now be described in slightly greater detail.

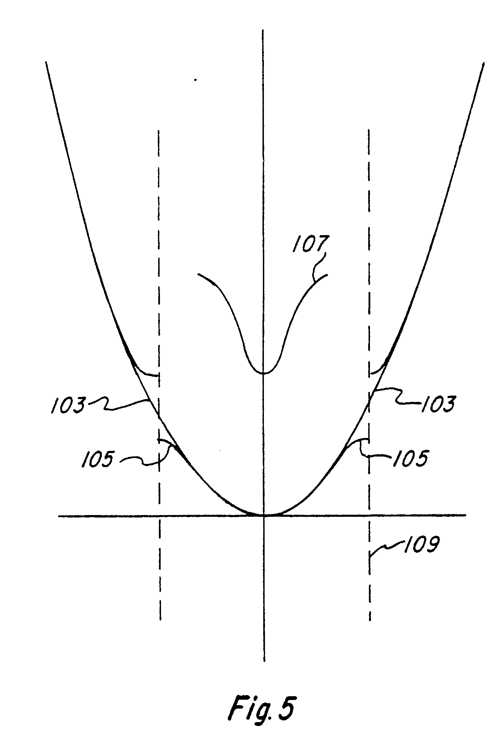

Figure 5 shows the electronic structure of the conduction band of the superlattice layer 13 in slightly greater detail. The periodicity of the superlattice artificially imposes Brillouin-zone boundaries 109. These boundaries 109 deform the normal parabolic potential curve 103, so that, instead of the normal parabolic potential curve 103, a first mini band 105, which is slightly deformed near the artificial boundary 109, is provided. Moreover, the upper portion of the parabolic potential 103 is also deformed, and is translated by the spatial periodicity of the superlattice structure, to provide a second mini band 107. The advantage of this is that direct transitions in the conduction band are now possible. That is, a transition from first mini band 105 to second mini band 107 can occur at a constant value of the wave number k. This means that photon absorption need not be phonon assisted. This means that photons are absorbed with greater efficiency, as discussed above. The height of the injection barrier must be chosen to be less than the height of the second mini band, so that the carriers which are injected into a second mini band 107 by photon absorption will be injected over the injection barrier, as discussed above.

It should be noted that this structure gives a quite sharp long wavelength cutoff. If the absorption band of the structure is excessively large, then of course short-wave length absorbing materials can simply be coated onto the surface of the structure.

Preferably the superlattice uses N-type background material, to take advantage of the lower electron mass. The background material of the superlattice is periodically alternated with very thin layers of a different material, to impose a periodic disturbance. The different material is preferably in layers thin enough (about one monolayer in the preferred embodiment) that carriers can tunnel through it easily. This means that carriers generated in any portion of the superlattice structure 13 can travel through the superlattice structure 13 to be injected over the barrier into the collection layer 15. The thin alternating layers need not be merely layers of a different-band gap-semiconductor, but can be formed of almost anything which imposes a periodic disturbance in the lattice characteristics, as long as the lattice crystal structure is perfectly preserved. Thus, as is known in the art, superlattice structures can be formed which have thin layers of metal or of insulator interspersed with the semiconductor layers More information on this aspect can be found in the article of L. Esaki et al "Superfine Structures of Semiconductors grown by Molecular-Beam Epitaxy" published in "CRC Critical Reviews in Solid State Science," pages 195-207 (April 1976). It should also be noted that, although the presently preferred embodiment of the invention uses a photocapacitor structure, in which the carriers injected into collector layer 15 are collected at a collection barrier which is the heterojunction between collection layer 15 and a barrier layer 19, this not strictly necessary. A further embodiment of the invention is configured as a photoconductor, wherein the carriers injected into collection layer 15 are not merely stored in a collection well, but provided as an output current. Moreover, other embodiments are possible wherein, for example, the carriers injected into layer 15 are collected in an MIM (metal-insulator-metal) capacitor, or collected in other ways. In any case, a key teaching of the present invention is that a superlattice is abutted to a heterojunction having a barrier height which is intermediate the energies of the first and second mini bands of a superlattice, so that carriers which make a transition to the second mini band of the superlattice can be injected over the injection heterojunction barrier and thus provide an output signal corresponding to infrared photons.

It should be noted that the present invention has been primarily described with reference to III-V compound semiconductor materials, since the technology of these materials is highly developed and well understood. That is, MBE formation of gallium arsenide and aluminum gallium arsenide epitaxial layers is easy. A particular advantage of this system is that a very good lattice match is preserved between gallium arsenide and aluminum gallium arsenide layers, and the interface quality is very good. Epitaxial heterojunctions between different-bandgap III-V materials are also possible with other materials, as is very well known in the art.

In addition, it is not, of course, necessary to form these structures by molecular beam epitaxy methods only, although this is the presently preferred method. Researchers working in chemical vapor deposition methods, such as organic-metallic chemical vapor deposition, have reported good results with abrupt hetero epitaxy and thin layers in this technology, but MBE is certainly the preferred fabrication technique. In particular, it is much easier to make a superlattice having one layer so thin as to be almost a monolayer using MBE methods.

In the presently preferred embodiment, as noted, N-type gallium arsenide is preferably used for the thick layers of the superlattice. The superlattice period is calculated, in accordance with the energy of the longest-wavelength photon which is desired to be detected, as follows: the superlattice spacing L is selected so that is equal to the energy of the photon, where k in this equation is equal to $\frac{2}{L}$ n. Thus, detection of longer-wavelength photons requires larger superlattice periodicity. For five micron radiation, the energy of a photon (h x v) is about 0.25 electron volts, or 2 x 7 Joules. In gallium arsenide the effective mass of an electron $m^*$ is equal to about 7% of its isolated mass $m_o$, and h is Planck's constant, so this formula indicates a superlattice spacing of 9,3 hm (93 angstroms)

The doping of the N-type gallium arsenide is preferably fairly heavy, to provide a large number of carriers, and therefore a good cross section for absorption of photons. In the presently preferred embodiment, the doping level of the absorption level 13 is high, preferably $2 \times 10^{18}$ or more, to provide a large cross section for absorption of photons. Preferably the collection region 15 is approximately intrinsic, i.e. not intentionally doped.

Two photo capacitors embodiments have been described. In one, the collection layer forms a heterojunction with an even higher-band gap epitaxial barrier layer, eg. pure aluminum arsenide, and a gate 25 is provided atop this barrier layer. Alternatively, the signal charge can be collected in an MIS diode, which can comprise, e.g., a layer 23 of an insulator and a layer 25 of a conductor on top of the collection layer 15.

The maximum on the practical doping level of the absorption layer 13 is imposed by dark current. That is, the number of carriers in the first mini band must not be so high as to spill over into the second mini band, which would cause dark current to be injected into the collection layer, nor even so high as to provide many carriers within a few kT of the injection barrier height at the operating temperature, again to avoid excess dark current.

In general, to reduce polarization sensitivity and thereby improve the ratio of signal current to dark current, the absorption layer I3 can be further modified, so it is not only vertically periodic as discussed above, but also laterally periodic with dimensions comparable to the vertical periodicity. This lateral periodicity increases the quantum efficiency of the device, but requires greatly increased processing cost, and is therefore not presently preferred.

It should be noted that the present invention is believed to be the first to teach use of III-V materials for long infrared absorption. II-VI superlattice structures have been previously proposed, but the materials and processing characteristics of III-V materials are generally much better understood and much more favorable.

Though the invention has been described with respect to a specific preferred embodiment thereof, many variations and modifications will immediately become apparent to those skilled in the art. It is therefore the intention that the appended claims be interpreted as broadly as possible in view of the prior art to include all such variations and modifications.

## Claims

1. A semiconductor detector for infrared radiation, comprising:

on a semiconductor substrate (11), a semiconductor superlattice (13) with first and second mini-bands, said second mini-band at an energy level higher than said first mini-band, said superlattice (13) doped with carriers substantially filling said first mini-band but being absent from said second mini-band;

a semiconductor collection layer (15) abutting said superlattice (13) and forming a heterojunction (17), said collection layer (15) being lattice-matched to said superlattice (13) and having a conduction-band edge at an energy level between said mini-bands' energy levels, whereby infrered radiation excites carriers from said first mini-band to said second mini-band, and said excited carriers are injected into said collection layer (15); and

a sensor coupled to said collection layer (15) to detect carriers in said collection layer (15).

2. The detector of claim 1, wherein:

the superlattice (13) is made of alternating layers of gallium arsenide and a first aluminum gallium arsenide alloy;

the collector (15) is made of a second aluminum gallium arsenide alloy;

the superlattice (13) is doped n-type, carriers being electrons.

3. An infrared imaging device for detecting infrared radiation, comprising:

a plurality of infrared detectors (1) arranged into rows and columns, each of said detectors (1) including:

on a semiconductor substrate (11), a semiconductor superlattice (13) with first and second mini-bands, said second mini-band at an energy level higher than said first mini-band, said superlattice (13) doped with carriers substantially filling said first mini-band but being absent from said second mini-band;

a semiconductor collection layer (15) abutting said superlattice (13) and forming a heterojunction (17), said collection layer (15) being lattice-matched to said superlattice (13) and having a conduction-band edge at an energy level between said minibands' energy levels, whereby infrared radiation excites carriers from said first mini-band to said second mini-band, and said excited carriers are injected into said collection layer (15); and

a sensor coupled to said collection layer (15) to detect carriers in said collection layer (15), said sensor being coupled to said collection layer (15) via a FET device (3) to column lines (5) and row lines (7) for addressing each of said sensors.

4. The imaging device of claim 3, wherein:

each superlattice (13) is made of alternating layers (31) of gallium arsenide and a first aluminum gallium arsenide alloy;

each collector (33) is made of a second aluminum gallium arsenide alloy;

each superlattice (13) is doped n-type, the carriers being electrons.

## Revendications

1. Détecteur à semi-conducteur de rayonnements infrarouges, comprenant :

sur un substrat semi-conducteur (11), un super-réseau semi-conducteur (13) avec une première et et une seconde mini-bandes, ladite seconde mini-bande ayant un niveau d'énergie supérieur à celui de ladite première mini-bande, ledit super-réseau (13) étant dopé avec des porteurs remplissant pratiquement ladite première mini-bande mais étant absents de ladite seconde mini-bande ;

une couche semi-conductrice destinée à recueillir (15) en appui sur ledit super-réseau (13) et formant une hérérojonction (17), ladite couche destinée à recueillir (15) étant adaptée en réseau audit superréseau (13) et ayant un bord de bande de conduction à un niveau d'énergie compris entre les niveaux d'énergie desdites mini-bandes.

de manière qu'un rayonnement infrarouge excite des porteurs de ladite première mini-bande, vers ladite seconde mini-bande et que lesdits porteurs excités soient injectés dans ladite couche destinée à recueillir (15) ; et

un capteur couplé avec ladite couche destinée à recueillir (15) pour détecter des porteurs dans ladite couche destinée à recueillir (15).

2. Détecteur selon la revendication 1 dans lequel :

le super-réseau (13) est constitué par des couches alternées d'arséniure de gallium et d'un premier alliage d'aluminium et de gallium ;

le collecteur (15) étant constitué par un second alliage d'arséniure d'aluminium et de gallium ;

le super-rèseau (13) est dopé du type N, les porteurs étant des électrons.

3. Dispositif de formation d'image en infrarouges destiné à détecter un rayonnement infrarouge, comportant :

plusieurs détecteurs d' infrarouges (1) agencés en rangées et en colonnes, chacun desdits détecteurs (1) comportant :

sur un substrat semi-conducteur (11), un superréseau semi-conducteur (l3) avec une première et une seconde mini-bandes, ladite seconde mini-bande ayant un niveau d'énergie supérieur à celui de ladite première mini-bande, ledit super-réseau (13) étant dopé avec des porteurs remplissant pratiquement ladite première mini-bande mais étant absents de ladite seconde mini-bande ;

une couche semi-conductrice destinée à recueillir (15) en appui sur ledit super-réseau (13) et formant une hétérojonction (17), ladite couche destinée à recueillir (15) étant adaptée en réseau audit super-réseau (13) et ayant un bord de bande de conduction à un niveau d'énergie compris entre les niveaux d'énergie desdites mini-bandes,

de manière qu'un rayonnement infrarouge excite des porteurs de ladite première mini-bande vers ladite seconde mini-bande et que lesdits porteurs soient injectés dans ladite couche destinée à recueillir (15) ; et

un capteur couplé avec ladite couche destinée à recueillir (15) pour détecter des porteurs dans ladite couche destinée à recueillir (15), ledit capteur étant couplé avec ladite couche destinée à recueillir (15) par un dispositif FET (3) pour des lignes de colonnes (5) et des lignes de rangées (7) afin d'adresser chacun desdits capteurs.

4. Dispositif de formation d'image selon la revendication 3, dans lequel :

chaque super-réseau (13) est constitué par des couches alternées (31 ) d'arséniure de gallium et d'un premier alliage d'arséndure d'aluminium et de gallium ;

chaque collecteur (33) est constitué par un second alliage d'arséniure d'aluminium et de gallium ;

chaque super-réseau (13) est dopé du type N, les porteurs étant des électrons.

## Ansprüche

1. Halbleiterdetektor für Infrarotstrahlung mit einem auf einem Halbleitersubstrat (11) befindlichen Halbleiter-Übergitter (13) mit ersten und zweiten Minibändern, von denen das zweite Miniband auf einem höheren Energieniveau liegt als das erste Miniband, wobei das Übergitter (13) mit Trägern dotiert ist, die das erste Miniband im wesentlichen ausfüllen, jedoch im zweiten Miniband fehlen, einer an das Übergitter (13) angrenzenden Halbleiter-Sammelschicht (15), die einen Heteroübergang (17) bildet, wobei die Sammelschicht (15) gittermäßig an das Übergitter (13) angepaßt ist und eine Leitungsbandkante auf einem zwischen den Energieniveaus der Minibänder liegenden Energieniveau aufweist, wodurch Infrarotstrahlung Träger aus dem ersten Miniband in das zweite Miniband anregt und die angeregten Träger in die Sammelschicht (15) injiziert werden, und einem Sensor, der mit der Sammelschicht (15) zum Detektieren von Trägern in diese Sammelschicht (15) gekoppelt ist.

2. Detektor nach Anspruch 1, bei welchem das Übergitter (13) als abwechselnden Schichten aus Galliumarsenid und einer ersten Aluminium-Galliumarsenid-Legierung gebildet ist, der Kollektor (15) aus einer zweiten Aluminium-Galliumarsenid-Legierung gebildet ist, das Übergitter (13) n-dotiert ist und die Träger Elektronen sind.

3. Infrarot-Abbildungsvorrichtung zum Detektieren von Infrarotstrahlung, mit mehreren in Reihen und Spalten angeordneten Infrarotdetektoren (1), wobei jeder der Dektektoren (1) folgendes enthält:

   ein auf einem Halbleitersubstrat (11) befindliches Halbleiter-Übergitter (13) mit ersten und zweiten Minibändern, von denen das zweite Miniband auf einem höheren Energieniveau liegt als das erste Miniband, wobei das Übergitter (13) mit Trägern dotiert ist, die das erste Miniband im wesentlichen ausfüllen, jedoch im zweiten Miniband fehlen, eine Halbleiter-Sammelschicht (15), die an das Übergitter (13) angrenzt und einen Heteroübergang (17) bildet, wobei die Sammelschicht (15) gittermäßig an das Übergitter (13) angepaßt ist und eine Leitungsbandkante auf einem zwischen den Energieniveaus der Minibänder liegenden Energieniveau aufweist, wodurch Infrarotstrahlung Träger aus dem ersten Miniband in das zweite Miniband anregt, wobei die angeregten Träger in die Sammelschicht (15) injiziert werden, und einen mit der Sammelschicht (15) gekoppelten Sensor zum Detektieren von Trägern in der Sammelschicht (15), wobei der Sensor mit der Sammelschicht (15) über eine FET-Vorrichtung (3) an Spaltenleitungen (5) und Reihenleitungen (7) zum Adressieren jedes der Sensoren gekoppelt ist.

4. Abbildungsvorrichtung nach Anspruch 3, bei welcher jedes Übergitter (13) aus abwechselnden Schichten (31) aus Galliumarsenid und einer ersten Aluminium-Galliumarsenid-Legierung gebildet ist, jeder Kollektor (33) aus einer zweiten Aluminium-Galliumarsenid-Legierung gebildet ist, jedes Übergitter (13) n-dotiert ist und die Träger Elektronen sind.

Fig.1

Fig.2

SnO2 — 25
SiO2 — 23
ALy Ga(1−y)As — 19
ALx Ga(1−x)As — 15
GaAs/AlGaAs LATTICE n — 13
GaAs SUBSTRATE — 11
21
17

Fig.3

ALx Ga(1−x) As — 15
GaAs
AlGaAs
31
31
GaAs — 11
33
33
13

Fig.4

SURFACE
ALy Ga(1−y)As — 19
ALx Ga(1−x)As — 15
SUBSTRATE
GaAs n-TYPE LATTICE — 13
21
17
11

8

*Fig. 5*